# EUROPÄISCHE PATENTSCHRIFT

(11) **EP 2 452 356 B1**
(45) Veröffentlichungstag und Bekanntmachung des Hinweises auf die Patenterteilung: **05.06.2013**
(21) Anmeldenummer: 10728247.7
(22) Anmeldetag: 05.07.2010
(51) Int. Cl.: H01L 21/67, G03F 7/42, G03F 7/30

(54) **VERFAHREN UND VORRICHTUNG ZUR BEHANDLUNG VON SUBSTRATEN**
METHOD AND DEVICE FOR TREATING SUBSTRATES
PROCÉDÉ ET DISPOSITIF POUR TRAITER DES SUBSTRATS

(30) Priorität: 06.07.2009 DE 102009032217
(43) Veröffentlichungstag der Anmeldung: 16.05.2012
(73) Patentinhaber: Gebr. Schmid GmbH, 72250 Freudenstadt (DE)
(72) Erfinder: KAPPLER, Heinz, 72280 Dornstetten-Aach (DE); LAMPPRECHT, Jörg, 72175 Dornhan (DE)
(74) Vertreter: Patentanwälte Ruff, Wilhelm, Beier, Dauster & Partner
(86) Internationale Anmeldenummer: PCT/EP2010/059589
(87) Internationale Veröffentlichungsnummer: WO 2011/003880

(56) Entgegenhaltungen:
- EP-A1- 0 933 684
- WO-A1-89/10680
- US-A- 3 978 506
- US-A- 4 519 690
- US-A- 4 931 072
- US-A- 5 307 106
- US-A- 5 759 743
- US-A1- 2008 044 956

## Beschreibung

Die Erfindung betrifft ein Verfahren zur Behandlung von Substraten, insbesondere für die Herstellung von Photovoltaik-Modulen, sowie eine zur Durchführung dieses Verfahrens geeignete Vorrichtung.

In der Photovoltaik- sowie vor allem der Leiterplatten-Technik werden Resist-Schichten von den entsprechenden Substraten entfernt mittels einer Prozesslösung. Dabei werden zum Teil Prozesslösungen eingesetzt, die schäumen oder in Kombination mit dem Resist oder anderen Stoffen, mit denen sie bei dem Reinigen in Berührung kommen, zur Schaumbildung führen. Solche Resists sind wachsartige sogenannte Hot Melts oder Thermal Inks bzw. Polymere oder Farben, die mittels Druckern oder Photolithographie sowie Siebdruck aufgetragen werden können. Die genannte Schaumbildung kann zu Prozessunterbrechungen bzw. zu Anlagenstörungen führen, unter Umständen sogar so weit, dass die Prozesslösung gar nicht mehr eingesetzt werden können. Auch beim Umpumpen bzw. Sprühen der Prozesslösung auf die Substrate sowie ggf. auch in einem Rücklauf aus einer Prozesskammer in einen Tank oder Behälter kann Schaum entstehen.

Es werden zwar sogenannte Entschäumer als Zusatzstoffe zur Schaumreduzierung eingesetzt. Diese werden jedoch zunehmend aus Kostensowie Umweltschutzgründen abgelehnt, da sowohl eine TOC-Belastung des Abwassers als auch ein CSB-Wert steigen und damit die Einleitwerte für das Abwasser überschritten werden. Dies bedeutet also, dass die Belastung des Wassers mit organischen Stoffen zu hoch ist.

In der Patentschrift US 4,519,690 sind ein Verfahren und eine Vorrichtung zum Entwickeln oder Ablösen von Resistschichten vom alkalischen Typ, die sich auf zu belichtenden Substraten befinden, offenbart. Die zu behandelnden Substrate werden mittels eines Rollentransportsystems durch mehrere hintereinander liegende Behandlungskammern hindurchtransportiert, wobei sie in einer oder mehreren hintereinander liegenden Resistablösekammern über Sprüheinrichtungen mit einer entsprechenden Prozesslösung besprüht werden. Die Prozesslösung sammelt sich dann im unteren Bereich der Kammer und bildet dort ein entsprechendes Prozessbad. Mittels einer Pumpe wird die Prozesslösung im unteren Teil des Prozessbades abgesaugt und wieder den Sprüheinrichtungen zum Besprühen der Substrate zugeführt. An das Prozessbad ist ein Regenerationskreislauf für die Prozesslösung angekoppelt. Dazu wird die Prozesslösung zunächst einem Regeneriertank zugeführt, in den zwei Trennwände eingebracht sind und dem zwei Pumpen zugeordnet sind, um die zu regenerierende Prozesslösung in Zirkulation zu versetzen. Dem Regeneriertank sind zwei Reagenzientanks zugeordnet, um der Prozesslösung ein Adsorbens und ein Agens zur Steuerung des pH-Wertes zuzuführen. Vom Regeneriertank wird die Prozesslösung unter Beimischung eines Gases und eines Ausflockungsagens in einen ersten Strömungstank und von dort unter nochmaliger Beimischung des Gases und des Ausflockungsagens in einen zweiten Strömungstank geleitet, die beide mit je einer Trennwand zur Strömungsunterstützung versehen sind. Anschließend wird die regenerierte Prozesslösung in einem entsprechenden Vorratstank bevorratet, um von dort wieder dem Prozessbad zugeführt zu werden.

Der Erfindung liegt die Aufgabe zugrunde, ein eingangs genanntes Verfahren sowie eine zu dessen Durchführung geeignete Vorrichtung zu schaffen, mit denen Probleme des Standes der Technik vermieden werden können und insbesondere eine Schaumbildung in Prozesslösung beim Entfernen von Resist-Schichten von Substraten möglichst gering gehalten werden kann.

Gelöst wird diese Aufgabe durch ein Verfahren mit den Merkmalen des Anspruchs 1 sowie eine Vorrichtung mit den Merkmalen des Anspruchs 7. Vorteilhafte sowie bevorzugte Ausgestaltungen der Erfindung sind Gegenstand der weiteren Ansprüche und werden im folgenden näher erläutert. Manche der nachfolgend aufgezählten Merkmale werden nur für das Verfahren oder nur für die Vorrichtung genannt. Sie sollen jedoch unabhängig davon sowohl für das Verfahren als auch für die Vorrichtung gelten können. Der Wortlaut der Ansprüche wird durch ausdrückliche Bezugnahme zum Inhalt der Beschreibung gemacht.

Erfindungsgemäß ist vorgesehen, dass die Substrate zuerst in einem Haupt-Strippmodul und dann in einem Nach-Strippmodul mit der Prozesslösung benetzt werden. Prozesslösung sammelt sich in Behältern unter den Modulen bzw. zumindest in einem Behälter unter dem Haupt-Strippmodul. Dabei ist für das Nach-Strippmodul mindestens ein Behälter vorgesehen, wobei für das Haupt-Strippmodul mindestens zwei Behälter vorgesehen sind. Prozesslösung wird aus dem Haupt-Strippmodul zuerst in einen zweiten Behälter direkt eingeleitet, insbesondere mit einem mindestens einfach gebogenen oder abgewinkelten Rohr. Dieser zweite Behälter ist von einem ersten Behälter des Haupt-Strippmoduls weitgehend abgetrennt durch eine Wand dazwischen, welche allerdings flüssigkeitsdurchlässig ist durch Ausnehmungen, Löcher, Aussparungen odgl. in einem Bereich deutlich unterhalb des Oberflächenniveaus von darin befindlicher Prozesslösung. Insbesondere ist die Flüssigkeitsdurchlässigkeit möglichst weit unten in den Behältern vorgesehen. Die beiden Behälter können dabei durch das Einsetzen einer Wand in einen großen Behälter gebildet werden, also durch dessen Abtrennung. Die genannten Ausnehmungen odgl. sind dann entweder im unteren Bereich der Wand vorgesehen oder aber die Wand wird nicht ganz bis zum Boden eingesetzt. Aus dem ersten Behälter wird Prozesslösung entnommen, insbesondere mittels einer Pumpe abgepumpt, und erneut in den Verfahrenskreislauf zurückgeführt zur Benetzung der Substrate.

Somit ist also vorgesehen, dass sich im Haupt-Strippmodul die Prozesslösung in einem zweiten Behälter sammelt und dabei an dessen Oberfläche Schaum entsteht bzw. vorhandener Schaum zur Oberfläche aufsteigt. Durch die flüssigkeitsleitende Verbindung mit dem ersten Behälter ist dieser ebenfalls mit Prozesslösung befüllt, allerdings weitestgehend ohne Schaum. Somit kann dort im wesentlichen schaumfreie Prozesslösung entnommen werden für erneutes Besprühen bzw. Benetzen der Substrate.

Erfindungsgemäß ist weiter vorgesehen, dass Schaum in dem zweiten Behälter an der Oberfläche von darin befindlicher Prozesslösung über eine Seitenwand des Behälters bewegt wird, also sozusagen entfernt wird, in eine separate, daneben angeordnete Schaumwanne. Dies kann auf unterschiedliche Art und Weise erfolgen, beispielsweise mit mechanischen Schiebern, durch Anblasen mit Druckluft oder durch Besprühen, insbesondere Besprühen mit Prozesslösung selbst. Vor allem das Besprühen wird als vorteilhaft angesehen, da dabei nicht nur der Schaum sozusagen mechanisch bewegt wird, sondern auch zumindest teilweise aufgelöst bzw. zersetzt wird. In dieser Schaumwanne kann dann ebenfalls wiederum Prozesslösung vorhanden sein mit Schaum an der Oberfläche, wobei die Prozesslösung wiederum entnommen wird und vorteilhaft in den ersten Behälter zurückgeführt wird, besonders vorteilhaft wiederum durch Pumpen. Alternativ kann ein Abzweig an eine Abwasserableitung oder -aufbereitung vorgesehen sein.

Um das Bewegen des Schaums weg von dem zweiten Behälter in die Schaumwanne besser steuern zu können, wenn also der Schaum über eine Seitenwand des zweiten Behälters bewegt wird, kann hier eine Art höhenverstellbares Wehr bzw. eine Art Schottleiste vorgesehen sein. Diese kann jeweils in der Höhe so eingestellt werden, dass sie sich auf Höhe des Flüssigkeitsspiegels der Prozesslösung bzw. ein kleines Stück darüber befindet. Dadurch wird erreicht, dass lediglich Schaum über die Seite geschoben wird und möglichst keine Prozesslösung.

Auch in der Schaumwanne kann in vorteilhafter Ausgestaltung der Erfindung durch Besprühen, insbesondere wiederum mit Prozesslösung, der Schaum niedergeschlagen bzw. beseitigt werden.

In Bewegungsrichtung des Schaums auf die Schaumwanne zu können mehrere, hintereinander geschaltete Düseneinrichtungen bzw. Sprüheinrichtungen vorgesehen sein, um sozusagen den Schaum mehrfach niederzuschlagen sowie gut zu bewegen. Dann brauchen die einzelnen Einrichtungen nicht mit allzu großem Druck betrieben zu werden, was wiederum vorteilhaft ist für die Bewegung sowie die Umwandlung in Prozesslösung.

Zum Sammeln der Prozesslösung im Haupt-Strippmodul, unter Umständen auch im Nach-Strippmodul, kann jeweils eine Art Wanne odgl. vorgesehen sein als Sammelwanne mit einem tiefsten Punkt, von dem aus ein Rohr oder eine sonstige Leitung in einen genannten Behälter führt. Ein solches Rücklaufrohr kann eben durch die genannte Biegung oder allgemein seine Formgebung die Schaumbildung reduzieren bzw. den Schaum möglichst weitgehend wieder auflösen.

Das Rücklaufrohr kann vorteilhaft so ausgebildet sein, dass es unterhalb der Oberfläche der Prozesslösung im zweiten Behälter endet. Dadurch kann eine Schaumbildung beim Einleiten in den zweiten Behälter reduziert werden.

Ein Nach-Strippmodul kann ähnlich aufgebaut sein wie das Haupt-Strippmodul, also beispielsweise etwa gleich lang sein bzw. auch einen ersten und einen zweiten Behälter für die darin verwendete Prozesslösung aufweisen. Vorteilhaft ist das Nach-Strippmodul kürzer und einfacher aufgebaut und weist nur einen einzigen Behälter auf. In diesem wird wiederum die im Nach-Strippmodul verwendete Prozesslösung gesammelt, vorteilhaft ähnlich wie im Haupt-Strippmodul, und dann in den Behälter eingeleitet. Dafür kann wiederum ein vorbeschriebenes Rücklaufrohr vorgesehen sein. Bei dem vereinfachten Aufbau des Nach-Strippmoduls mit nur einem Behälter ist es möglich, die Prozesslösung von dort wiederum in einen der Behälter des Haupt-Strippmoduls zurückzuführen zur erneuten Verwendung dort. Dazu kann entweder wiederum eine flüssigkeitsdurchlässige Wandung vorgesehen sein bzw. eine mit Ausnehmungen odgl.. Alternativ kann eine Kaskade aus dem Behälter im Nach-Strippmodul vorgesehen sein, die ebenfalls unter möglichst weitgehender Vermeidung von Schaumbildung Prozesslösung überführt.

Sowohl im Haupt-Strippmodul als auch im Nach-Strippmodul können Sprüheinrichtungen odgl. für die Prozesslösung aus einem einzigen Behälter gespeist werden, nämlich dem ersten Behälter des Haupt-Strippmoduls. Dann kann sich die Vermeidung von Schaumbildung ganz auf die Prozesslösung in diesem Behälter konzentrieren.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

Ausführungsbeispiele der Erfindung sind in den Zeichnungen schematisch dargestellt und werden im folgenden näher erläutert. In den Zeichnungen zeigen:
- Fig. 1: eine schematische Seitendarstellung einer erfindungsgemäßen Anlage zur Behandlung von Substraten,
- Fig. 2: ein Haupt-Strippmodul und ein Nach-Strippmodul aus Fig. 1 in Vergrößerung mit Funktionsdarstellungen,
- Fig. 3: eine Ansicht auf das Haupt-Strippmodul gemäß Fig. 2 in Durchlaufrichtung der Substrate,
- Fig. 4: eine Draufsicht auf die Darstellung entsprechend Fig. 3 und
- Fig. 5: eine Ansicht eines Tauchbades anstelle von Sprührohren für die Substrate in einem alternativen Haupt-Strippmodul.

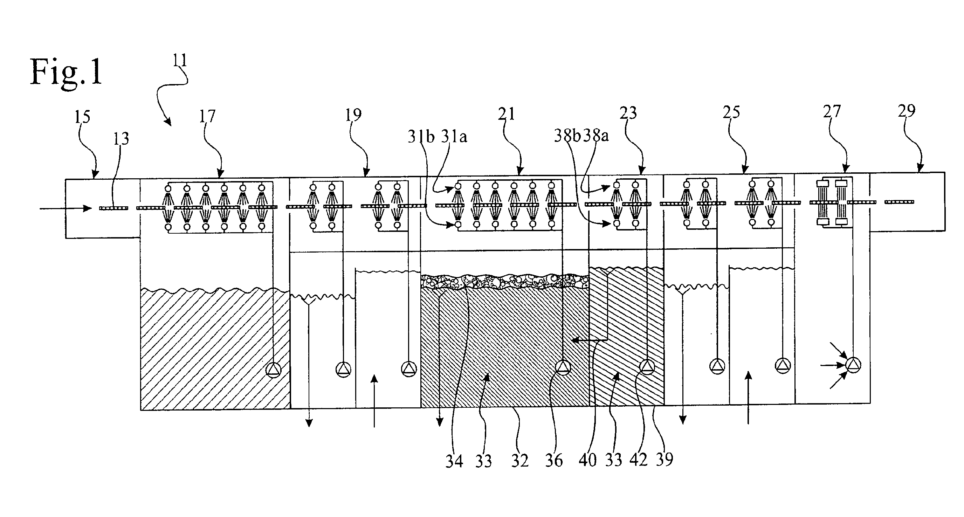

In Fig. 1 ist eine erfindungsgemäße Anlage 11 zur Behandlung von Substraten 13 dargestellt, wobei die Substrate 13 vorteilhaft für Solarzellen für Photovoltaik-Module sind. Die Anlage 11 weist auf an sich bekannte Weise ein Einfahrmodul 15 auf, an welches sich ein Ätzmodul 17 anschließt. Dort werden die Strukturen auf dem Substrat 13 durch Ätzen geöffnet, wie es auch bekannt ist, weswegen nicht näher darauf eingegangen werden muss. Nach dem Ätzmodul 17 kommt ein ebenfalls bekanntes Spülmodul 19.

Dann schließt sich ein Haupt-Strippmodul 21 an, wie es vorstehend allgemein erläutert worden ist, dem wiederum ein Nach-Strippmodul 23 folgt. Dann folgt wiederum ein zweites Spülmodul 25, ein Trockenmodul 27 und ein Ausfahrmodul 29. So werden die Substrate 13 in der Durchlaufrichtung von links nach rechts auf an sich bekannte Weise behandelt.

Das Haupt-Strippmodul 21 weist über der Substrate 13 bzw. ihrer Durchlaufbahn obere Sprührohre 31a auf und darunter untere Sprührohre 31 b. Diese sprühen jeweils Prozesslösung 33 auf die Substrate 13, was alternativ auch nur von einer Seite aus erfolgen könnte. Wie vorstehend beschrieben worden ist, werden mit der aufgesprühten Prozesslösung 33 die Substrate 13 von Resist befreit. Unterhalb der Substrate 13 befindet sich ein Behälter 32, in dem sich letztlich die Prozesslösung 33 sammelt. Auf der Oberfläche der Prozesslösung 33 befindet sich Schaum 34, der auf nachfolgend beschriebene Art und Weise möglichst vermieden bzw. beseitigt gemacht werden soll. Mittels einer Pumpe 36 wird Prozesslösung 33 aus dem Behälter 32 abgepumpt und den Sprührohren 31 a und 31 b wieder zugeführt zum weiteren Entfernen von Resist-Schichten von den Substraten 13.

Im Nach-Strippmodul 23 befinden sich obere Sprührohre 38a und untere Sprührohre 38b für die Substrate 13. Diese dienen dazu, Reste von Resist-Schichten von den Substraten 13 zu entfernen, wobei dies in der Regel nicht mehr sehr viele sind. Dies führt dazu, dass in dem Behälter 39 unter den Substraten 13 im Nach-Strippmodul 23 nur sehr wenig bzw. kaum Schaum entsteht, so dass dort fast nur Prozesslösung 33 enthalten ist. Mittels einer Kaskadenleitung 40 kann derartige, im wesentlichen schaumfreie Prozesslösung in den daneben liegenden Behälter 32 des Haupt-Strippmoduls 21 geleitet werden. Des weiteren kann über eine Pumpe 42 eine Versorgung der Sprührohre 38a und 38b mit Prozesslösung 33 erfolgen.

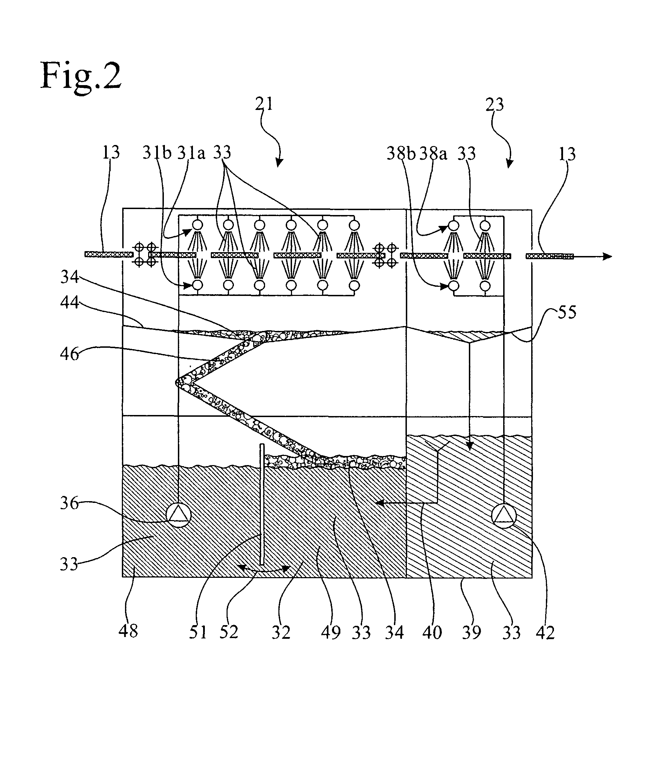

In der detaillierten Darstellung gemäß Fig. 2 ist zu sehen, dass sich unter den Substraten 13 bzw. ihrer Durchlaufbahn eine Sammelwanne 44 befindet. Diese sammelt sämtliche von den Sprührohren 31a und 31 b ausgebrachte Prozesslösung 33 und leitet sie mittels eines Rücklaufrohrs 46 in den Behälter 32, und zwar in einen rechten zweiten Tankbehälter 49. Das Rücklaufrohr 46 kann, wie dargestellt ist, einfach oder mehrfach gebogen, geknickt oder sonst wie ausgebildet sein, um darin geleitete Prozesslösung 33 schaumfrei oder möglichst schaumreduzierend in den zweiten Tankbehälter 49 einzuleiten. Ein Ende des Rücklaufrohrs 46 kann entweder nahe dem Oberflächenniveau der Prozesslösung 33 enden. Alternativ kann es tiefer enden, was in vielen Fällen zur weiteren Schaumreduzierung dient.

Auf der Oberfläche der Prozesslösung 33 im zweiten Tankbehälter 49 befindet sich sehr viel Schaum 34, da hier durch die abgelösten Resist-Anteile von den Substraten 13 die Schaumbildung verstärkt wird. In dem Behälter 32 ist durch eine Trennwand 51 auch noch ein erster Tankbehälter 48 gebildet. Dies kann einfach durch Einsetzen der Trennwand 51 in den Behälter 32 erfolgen. Dabei ist im unteren Bereich der Trennwand 51 eine Öffnung 52 vorgesehen, beispielsweise dadurch, dass die Trennwand 51 nicht ganz bis zum Boden verläuft. Alternativ könnten auch Öffnungen oder Durchbrüche bzw. Ausnehmungen in der Trennwand 51 vorgesehen sein. Somit sind der erste Tankbehälter 48 und der zweite Tankbehälter 49 flüssigkeitsleitend miteinander verbunden. Durch die Öffnung 52 im unteren Bereich findet nur ein Austausch von Prozesslösung 33 statt, also ohne Schaum 34. Dies bewirkt, dass im ersten Tankbehälter 48 eigentlich nur reine Prozesslösung 33 bzw. wenig Schaum enthalten ist.

In dem vergrößert dargestellten Nach-Strippmodul 23 ist ebenfalls eine Sammelwanne 55 vorgesehen, welche an sich auf sehr einfache Art und Weise die Prozesslösung 33 in den Behälter 39 einleiten kann. Da hier kaum Resist-Anteile in der Prozesslösung 33 enthalten sind oder gar keine, ist die Schaumbildung eben sehr reduziert. Alternativ kann ein Rücklaufrohr 46 ähnlich wie im Haupt-Strippmodul 21 vorgesehen sein.

Es ist zu erkennen, dass die Prozesslösung 33 im Behälter 39 keinen Schaum aufweist.

Des weiteren ist eine Kaskadenleitung 40 vorgesehen, um die Prozesslösung 33, welche schaumfrei und im wesentlichen Resist-frei und somit noch sehr unverbraucht ist, in den Behälter 32 einzuleiten, also sozusagen zur Auffrischung der dortigen Prozesslösung. Eine solche Kaskadenleitung 40 kann, ähnlich wie das Rücklaufrohr 46, zur Schaumvermeidung ausgebildet sein. Sie kann entweder in den ersten Tankbehälter 48 oder, wie dargestellt, in den zweiten Tankbehälter 49 führen.

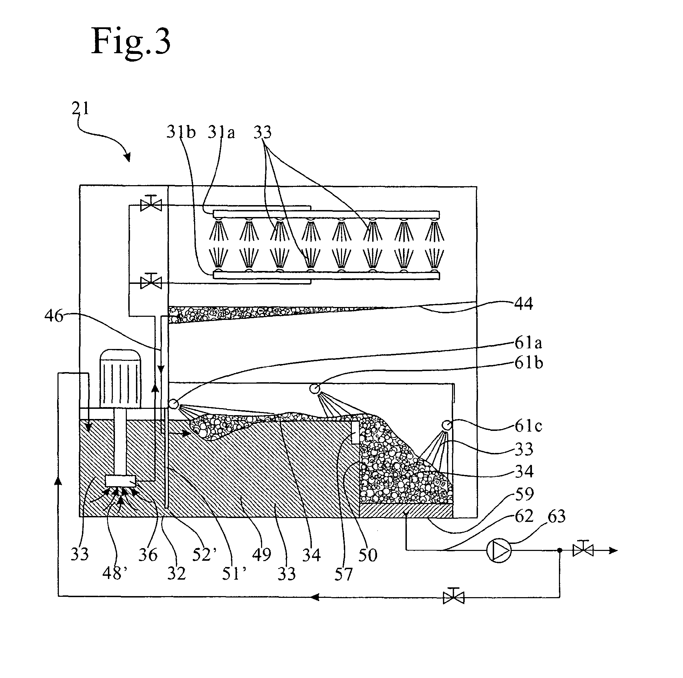

In Fig. 3 ist in Durchlaufrichtung der Substrate eine Schnittdarstellung durch das Haupt-Strippmodul 21 gezeigt. Es ist zu erkennen, dass auf dem zweiten Tankbehälter 49 gebildeter Schaum 34 behandelt bzw. bewegt wird. Dazu befindet sich rechts seitlich neben dem zweiten Tankbehälter 49 durch eine Seitenwand 50 getrennt eine Schaumwanne 59. In diese soll der Schaum 34 hineingebracht und niedergeschlagen werden, um die Prozesslösung 33 wieder verwenden zu können. Damit möglichst nur Schaum 34 nach rechts transportiert wird und keine Prozesslösung 33 aus dem zweiten Tankbehälter 49 abläuft, ist eine höhenverstellbare Schottleiste 57 vorgesehen. Diese kann so hoch gefahren werden, dass sie in etwa dem Oberflächenniveau der reinen Prozesslösung 33 im zweiten Tankbehälter 49 entspricht. Lediglich Schaum 34 wird dann noch nach rechts darüber bewegt in die Schaumwanne 59 hinein.

Zum Bewegen des Schaums 34 sind rohrartige längliche Schaumdüsen 61 a als Sprüheinrichtungen ganz links über dem zweiten Tankbehälter 49 vorgesehen und Schaumdüsen 61b nahe der Seitenwand 50 bzw. der Schottleiste 57. Diese Düsen heißen deswegen Schaumdüsen, weil sie zum Bewegen des Schaums oder sogar zum Niederschlagen ausgebildet sind und dazu dienen. Sie sollen aber keineswegs zur Erzeugung von Schaum dienen oder dieses fördern. Die Düsen können runde Düsenöffnungen aufweisen oder längliche, beispielsweise nach Art von Schlitzdüsen. Eine Mehrzahl oder sogar Vielzahl solcher Düsen ist an länglichen Rohren vorgesehen, weswegen sie eben als rohrartig und länglich bezeichnet werden.

Diese Schaumdüsen sind sämtlich nach rechts und schräg unten gerichtet, also in etwa in eine Richtung, die Schaumdüsen 61 a sogar in einem noch flacheren Winkel. Sie sprühen Prozesslösung 33 mit hohem Druck aus als einigermaßen feiner Nebel, der den Schaum 34 von der Oberfläche der Prozesslösung 33 im zweiten Tankbehälter 49 nach rechts in die Schaumwanne 59 treibt und bereits etwas niederschlägt, also reduziert.

Oberhalb der Schaumwanne 59 befinden sich dritte Schaumdüsen 61 c, deren Strahlrichtung von Prozesslösung 33 schräg nach links unten ist und zwar sozusagen auf die gesamte Oberfläche des Schaums 34 in der Schaumwanne 59. Dies dient nicht zum Bewegen des Schaums 34, sondern zum Niederschlagen, so dass er wieder die Form von reiner Prozesslösung 33 annimmt. Dann kann Prozesslösung 33 mittels einer Ableitung 62 und einer Drainagepumpe 63 aus der Schaumwanne 59 entnommen werden und entweder, je nach Zustand bzw. Resist-Gehalt, zu einer Abwasseraufbereitung führen oder aber zurück in den Kreislauf.

Links neben dem zweiten Tankbehälter 49 befindet sich ein erster Teil-Tankbehälter 48' des ersten Tankbehälters 48. Er ist durch eine Trennwand 50' mit im unteren Bereich vorgesehener Öffnung 52' getrennt und weist die zuvor beschriebene Pumpe 36 auf, die die Sprührohre 31a und 31 b versorgt.

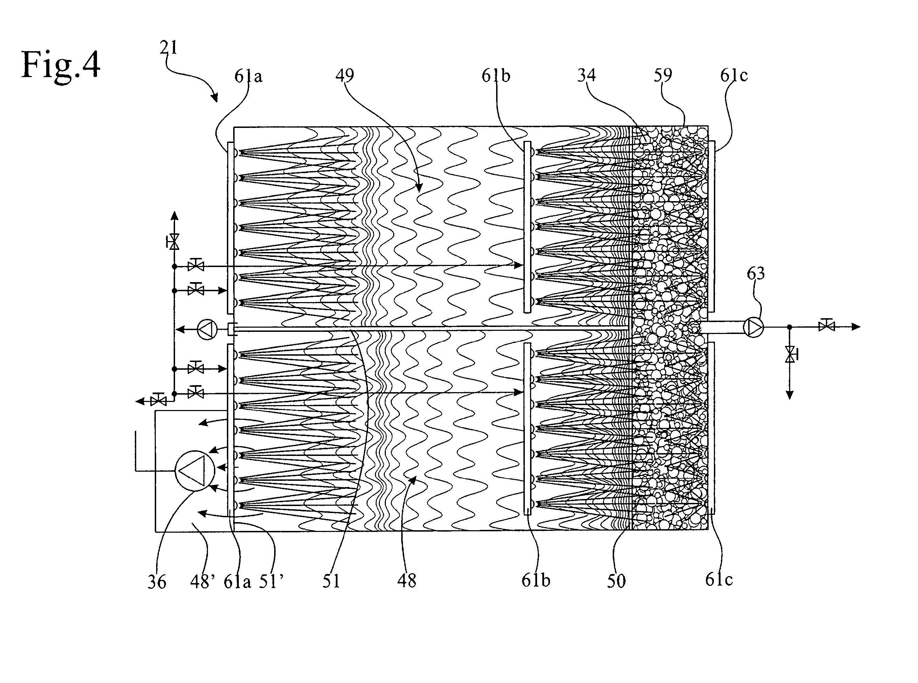

In der Draufsicht gemäß Fig. 4 ist zu erkennen, wie mittels der Schaumdüsen 61a und 61 b Schaum 34 auf der Oberfläche der Prozesslösung 33 sowohl über dem ersten Tankbehälter 48 als auch über dem zweiten Tankbehälter 49 in der Darstellung nach unten auf die Schaumwanne 59 zu bewegt wird. Zu erkennen ist auch die Trennwand 51 zwischen dem ersten Tankbehälter 48 und dem zweiten Tankbehälter 49. Links oben befindet sich der zuvor beschriebene erste Teil-Tankbehälter 48', abgetrennt vom ersten Tankbehälter 48 durch die genannte Trennwand 51'. Es ist zu erkennen, dass die Seitenwand 50 über die gesamte Breite vom ersten Tankbehälter 48 und zweiten Tankbehälter 49 nebeneinander verläuft und ebenso auch die Schaumwanne 59. Dasselbe gilt für die Schaumdüsen 61a, 61 b und 61c.

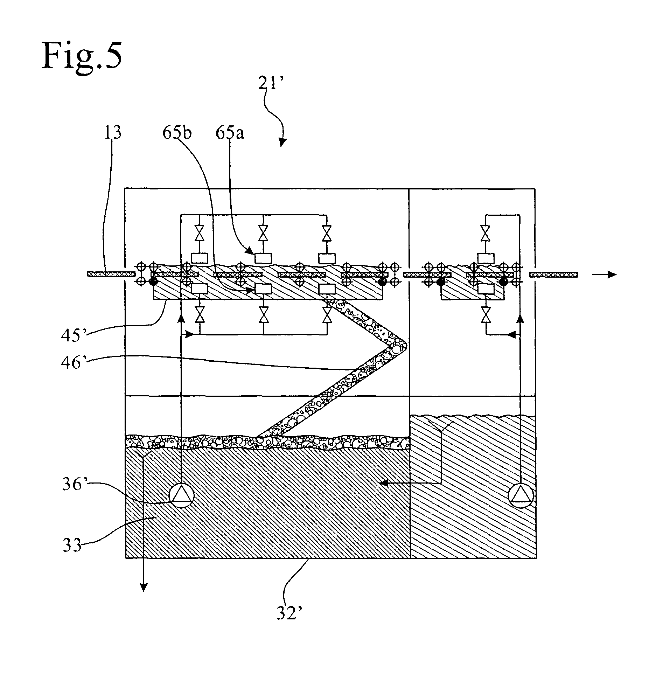

In Fig. 5 ist eine Abwandlung der Darstellung von Fig. 2 dargestellt mit einem Haupt-Stripp-Modul 21', bei dem der Behälter 32' mit Prozesslösung 33 darin sowie das Rücklaufrohr 46' der Ausführung aus Fig. 2 entsprechen. Die Abwandlung besteht hier darin, dass die Substrate 13 nicht sozusagen frei in der Luft von einer Rollentransportbahn transportiert werden und mit den Sprührohren 31 besprüht werden, sondern durch ein Tauchbad 45' gefahren werden. Dabei dienen Schwallrohre 65a und 65b über und unter den Substraten dazu, selbst beim Eintauchen noch zusätzlich die Prozesslösung 33 zu durchmischen und somit die Behandlungswirkung zu verstärken. Für die oberen Schwallrohre 65a gilt, dass diese als Schwallrohre in die Prozesslösung 33 eingetaucht sein können oder aber teils eingetaucht sind und teils darüber stehen, und dann möglicherweise eben auch eine Sprühfunktion bewirken können. Versorgt werden die Schwallrohre 65a und 65b mittels einer Pumpe 36' im Flüssigkeitsbehälter 32'.

Aus Fig. 5 ist zu entnehmen, dass hier das Prinzip des Tauchbads auch bei dem Nach-Stripp-Modul rechts daneben realisiert ist, was aber nicht zwingend so sein muss. Auf eine genaue Erläuterung kann hier deswegen verzichtet werden. Grundsätzlich ist die Behandlung von Substraten in einem Tauchbach anstelle von Besprühen bekannt. Insofern ist auch die technische Umsetzung für den Fachmann nicht schwierig. Der Vorteil liegt hier vor allem darin, dass weniger Schaum in der Kammer des Haupt-Stripp-Moduls 21 entsteht. Auch Kombinationen davon sind möglich.

Dargestellt ist hier die Anwendung der Erfindung in einzelnen Prozesskammern bzw. -modulen, bei denen die Substrate besprüht werden oder im Durchlaufbad bzw. Tauchbad getaucht werden. Sie kann aber auch vorteilhaft bei Bädern mit sogenannten stehenden Wellen verwendet werden, so dass eine flächige Benetzung ohne Eintauchen erfolgen kann. Sie kann auch kombiniert mit Ultraschall effektiv angewendet werden.

## Patentansprüche

1. Verfahren zur Behandlung von Substraten, insbesondere für die Herstellung von Photovoltaik-Modulen, wobei in einem Verfahrensschritt Resist-Schichten von den Substraten entfernt werden durch Besprühen bzw. Benetzen mit einer in einem Kreislauf geführten Prozesslösung (33), wobei die Substrate zuerst in einem Haupt-Strippmodul (21) und dann in einem Nach-Strippmodul (23) mit der Prozesslösung besprüht bzw. benetzt werden und die Prozesslösung in Behältern unter den Modulen gesammelt wird, wobei für das Haupt-Strippmodul und das Nach-Strippmodul jeweils mindestens ein Behälter vorgesehen wird und der oder die Behälter des Haupt-Strippmoduls von dem oder den Behältern des Nach-Strippmoduls getrennt ist/sind, **dadurch gekennzeichnet, dass**
- die Prozesslösung in dem Haupt-Strippmodul in einem ersten (48, 48') und einem zweiten Behälter bevorratet wird und dabei zuerst in den zweiten Behälter (49) geleitet wird, der von dem ersten Behälter abgetrennt ist durch eine Wand (51, 51'), die flüssigkeitsdurchlässig ist durch Ausnehmungen oder dergleichen in einem Bereich unterhalb eines Oberflächenniveaus von darin befindlicher Prozesslösung,
- aus dem ersten Behälter die Prozesslösung entnommen und in den Kreislauf zurückgeführt wird zum Besprühen bzw. Benetzen der Substrate,
- Schaum in dem zweiten Behälter (49) an der Oberfläche der Prozesslösung über eine Seitenwand (50) des Behälters bewegt wird in eine separate, daneben angeordnete Schaumwanne (59) und
- zusammengefallener Schaum bzw. Reinigungsprozesslösung aus der Schaumwanne (59) entnommen bzw. abgepumpt wird und in den ersten Behälter (48,48') zurückgeführt wird.

2. Verfahren nach Anspruch 1, **dadurch gekennzeichnet, dass** die Prozesslösung in einem Rücklaufrohr (46) von einer flächigen Sammeleinrichtung (44) im Haupt-Strippmodul in den zweiten Behälter eingeleitet wird.

3. Verfahren nach Anspruch 2, **dadurch gekennzeichnet, dass** durch Formgebung des Rücklaufrohres, insbesondere mit mindestens einer Biegung, die Schaumbildung reduziert wird.

4. Verfahren nach Anspruch 3, **dadurch gekennzeichnet, dass** das Rücklaufrohr unterhalb eines Oberflächenniveaus der Prozesslösung im zweiten Behälter endet.

5. Verfahren nach einem der Ansprüche 1 bis 4, **dadurch gekennzeichnet, dass** der Schaum durch Sprüheinrichtungen (61a, 61b) in die Schaumwanne bewegt wird und/oder in der Schaumwanne von oben mittels Sprüheinrichtungen (61 c) mit der Prozesslösung besprüht wird zum Niederschlagen des Schaums bzw. Beseitigen des Schaums und Umwandeln in die Prozesslösung.

6. Verfahren nach einem der vorhergehenden Ansprüche, **dadurch gekennzeichnet, dass** die Prozesslösung aus dem Nach-Strippmodul (23) bzw. einem dort vorgesehenen Behälter in den zweiten Behälter im Haupt-Strippmodul geführt wird, insbesondere über mindestens eine Kaskade geleitet wird.

7. Vorrichtung zur Behandlung von Substraten, insbesondere für die Herstellung von Photovoltaik-Modulen, vorzugsweise zur Durchführung des Verfahrens nach einem der vorhergehenden Ansprüche, mit
- einem Haupt-Strippmodul (21) und einem nachfolgenden Nach-Strippmodul (23), die Sprüheinrichtungen (31a, 31b, 38a, 38b) oder Benetzungseinrichtungen aufweisen, um die Substrate entlang eines Transportwegs durch die Strippmodule mit einer in einem Kreislauf geführten Prozesslösung (33) zu besprühen bzw. zu benetzen,
**dadurch gekennzeichnet, dass**
- das Haupt-Strippmodul (21) einen ersten (48, 48') und einen zweiten Behälter (49) für die Prozesslösung aufweist, wobei die Prozesslösung nach Besprühen bzw. Benetzen der Substrate in den zweiten Behälter geleitet wird, der von dem ersten Behälter abgetrennt ist durch eine Wand (51, 51'), die flüssigkeitsdurchlässig ist durch Ausnehmungen oder dergleichen in einem Bereich deutlich unterhalb eines Oberflächenniveaus von darin befindlicher Prozesslösung,
- Mittel (36) zum Entnehmen der Prozesslösung aus dem ersten Behälter und Rückführen in den Kreislauf zum Besprühen bzw. Benetzen der Substrate vorgesehen sind,
- eine Schaumwanne (59) an einem Seitenbereich des zweiten Behälters angeordnet ist und
- Mittel (61 a, 61 b) oberhalb des zweiten Behälters zum Bewegen von Schaum an der Oberfläche der Prozesslösung in den zweiten Behälter über eine Seitenwand (50) des zweiten Behälters (49) in die Schaumwanne vorgesehen sind.

8. Vorrichtung nach Anspruch 7, **gekennzeichnet durch** eine flächige Sammeleinrichtung (44) im Haupt-Strippmodul mit einem Rücklaufrohr (46), das in den zweiten Behälter führt.

9. Vorrichtung nach Anspruch 8, **dadurch gekennzeichnet, dass** das Rücklaufrohr (46) in den zweiten Behälter (49) unter ein Oberflächenniveau von darin befindlicher Prozesslösung, vorzugsweise in das untere Drittel, geführt ist.

10. Vorrichtung nach Anspruch 8 oder 9, **dadurch gekennzeichnet, dass** das Rücklaufrohr (46) zur Reduzierung einer Schaumbildung von hindurchfließender Prozesslösung ausgebildet ist, insbesondere durch mindestens eine Biegung.

11. Vorrichtung nach einem der Ansprüche 7 bis 10, **gekennzeichnet durch** eine Sprüheinrichtung (61 c), die in das Innere der Schaumwanne (59) gerichtet ist zum Niederschlagen von darin befindlichem Schaum als Prozesslösung.

12. Vorrichtung nach einem der Ansprüche 7 bis 11, **gekennzeichnet durch** ein Tauchbad (45') mit Prozesslösung für die Substrate im Haupt-Strippmodul als Benetzungseinrichtung, insbesondere auch im Nach-Strippmodul, wobei vorzugsweise ein Überlauf aus dem Tauchbad in den zweiten Behälter vorgesehen ist.

13. Vorrichtung nach Anspruch 12, **gekennzeichnet durch** Schwallrohre (65a, 65b) oberhalb und unterhalb einer Durchlaufbahn für Substrate **durch** das Tauchbad zum gezielten Aufbringen bzw. Benetzen mit Prozesslösung.

14. Vorrichtung nach einem der Ansprüche 7 bis 13, **gekennzeichnet durch** eine kaskadierende Leitung (40) von einem Behälter zum Sammeln von Prozesslösung im Nach-Strippmodul in den zweiten Behälter des Haupt-Strippmoduls.

## Claims

1. A method for treating substrates, in particular for producing photovoltaic modules, wherein in one method step resist layers are removed from the substrates by spraying or wetting with a circulating process solution (33), wherein the substrates are wetted with the process solution first in a main stripping module (21) and then in a post stripping module (23), and the process solution collects in containers under the modules, wherein at least one container is provided for the main stripping module and the post stripping module, respectively, and the one or more container(s) of the main stripping module is/are separated from the one or more container(s) of the post stripping module, **characterized in that**
- the process solution in the main stripping module is stored in a first (48, 48') and a second container, and is first fed directly into the second container (49), which is separated from the first container by a wall (51, 51') which is liquid-permeable as a result of clearances or the like in a region well below a surface level of process solution contained therein,
- process solution is removed from the first container and returned once again into the cycle of the process for spraying or wetting the substrates,
- froth in the second container (49), on the surface of the process solution, is moved over a side wall (50) of the container into a separate froth pan (59) arranged alongside, and
- disintegrated froth or cleaning process solution is removed or pumped out of the froth pan (59) and returned into the first container (48, 48').

2. The method according to Claim 1, **characterized in that** the process solution is fed into the second container in a return pipe (46) from a collecting device (44) of a flat form in the main stripping module.

3. The method according to Claim 2, **characterized in that** froth formation is reduced by shape design of the return pipe, in particular having at least one bend.

4. The method according to Claim 3, **characterized in that** the return pipe ends below the surface level of the process solution in the second container.

5. The method according to any of claims 1 to 4, **characterized in that** froth is moved by spraying devices (61 a, 61 b) in the froth pan and/or is sprayed in the froth pan with process solution from above by means of spraying devices (61 c) for breaking down the froth or eliminating the froth and converting it into process solution.

6. The method according to any of the preceding claims, **characterized in that** process solution from the post stripping module (23) or a container provided there is directed into the second container in the main stripping module, in particular by means of at least one cascade.

7. An apparatus for treating substrates, in particular for producing photovoltaic modules, preferably for performing the method according to any of the preceding claims, comprising
- a main stripping module (21) and a downstream post-stripping module (23) including spraying devices (31 a, 31 b, 38a, 38b) or wetting devices for applying circulating process solution (33) by spraying or wetting to substrates along a transporting path through the stripping modules,
**characterized in that**
- the main stripping module (21) has a first (48, 48') and a second container (49) for the process solution, wherein the process solution after spraying or wetting of the substrates is fed into the second container that is separated from the first container by a wall (51, 51') which is liquid-permeable as a result of clearances or the like in a region well below a surface level of process solution contained therein,
- means (36) are provided for removing the process solution from the first container and returning it to the cycle of the process for spraying or wetting the substrates, and
- means (61 a, 61 b) are provided above the second container for moving froth on the surface of the process solution in the second container over a side wall (50) of the second container (49) into the froth pan.

8. The apparatus according to Claim 7, **characterized by** a collecting device (44) of a flat form in the main stripping module with a return pipe (46) which leads into the second container.

9. The apparatus according to Claim 8, **characterized in that** the return pipe (46) is led into the second container (49) below a surface level of process solution contained therein, preferably into the lower third thereof.

10. The apparatus according to Claim 8 or 9, **characterized in that** the return pipe (46) is designed for reducing froth formation of process solution flowing through, in particular by at least one bend.

11. The apparatus according to any of Claims 7 to 10, **characterized by** a spraying device (61 c) directed into the interior of the froth pan (59) for breaking down froth contained therein as process solution.

12. The apparatus according to any of Claims 7 to 11, **characterized by** an immersion bath (45') with process solution for the substrates in the main stripping module as a wetting device, in particular also in the post-stripping module, wherein preferably an overflow from the immersion bath into the second container is provided.

13. The apparatus according to Claim 12, **characterized by** surge pipes (65a, 65b) above and below a running-through path for substrates through the immersion bath for specifically directed application or wetting with process solution.

14. The apparatus according to any of Claims 7 to 13, **characterized by** a cascading line (40) from a container for collecting process solution in the post-stripping module into the second container of the main stripping module.

## Revendications

1. Procédé de traitement de substrats, en particulier en vue de la fabrication de modules photovoltaïques, et dans lequel au cours d'une étape des couches de vernis sont enlevées des substrats par pulvérisation ou mouillage à l'aide d'une solution de traitement (33) maintenue en recirculation,
la solution de traitement étant pulvérisée sur les substrats ou mouillant les substrats d'abord dans un module d'enlèvement principal (21) et ensuite dans un module (23) de finition d'enlèvement et la solution de traitement étant recueillie dans des récipients situés en dessous des modules,
au moins un récipient étant prévu respectivement pour le module d'enlèvement principal et pour le module d'enlèvement de finition et le ou les récipients du module d'enlèvement principal étant séparés du ou des récipients du module de finition d'enlèvement,
**caractérisé en ce que**
la solution de traitement présente dans le module d'enlèvement principal est conservée dans un premier (48, 48') et un deuxième récipient et est amenée d'abord dans le deuxième récipient (49) séparé du premier récipient par une paroi (51, 51'), rendue perméable aux liquides par des découpes ou similaires réalisées dans une partie située en dessous du niveau de la surface de la solution de traitement qui s'y trouve,
**en ce que** la solution de traitement est enlevée du premier récipient et est renvoyée dans le circuit pour pulvériser ou mouiller les substrats,
**en ce que** la mousse présente à la surface de la solution de traitement reprise dans le deuxième récipient (49) est déplacée par une paroi latérale (50) du récipient dans une cuve (59) à mousse séparée et située en dessous et
**en ce que** la mousse recueillie ou la solution de nettoyage recueillie est enlevée ou pompée de la cuve (59) à mousse et est renvoyée dans le premier récipient (48, 48').

2. Procédé selon la revendication 1, **caractérisé en ce que** la solution de traitement est introduite dans le deuxième récipient par un tube de renvoi (46) depuis un dispositif plat de collecte (44) prévu dans le module d'enlèvement principal.

3. Procédé selon la revendication 2, **caractérisé en ce que** la formation de mousse est réduite par la forme du tube de renvoi qui présente en particulier au moins un coude.

4. Procédé selon la revendication 3, **caractérisé en ce que** le tube de renvoi se termine en dessous du niveau de surface de la solution de traitement présente dans le deuxième récipient.

5. Procédé selon l'une des revendications 1 à 4, **caractérisé en ce que** la mousse est déplacée dans la cuve à mousse par des dispositifs de pulvérisation (61a, 61b) et/ou est aspergée par de la solution de traitement au moyen de dispositifs de pulvérisation (61 c) situés par dessus, pour rabattre la mousse ou éliminer la mousse et la ramener dans la solution de traitement.

6. Procédé selon l'une des revendications précédentes, **caractérisé en ce que** la solution de traitement provenant du module (23) de finition d'enlèvement ou d'un récipient qui y est prévu est amenée dans le deuxième récipient du module d'enlèvement principal, en particulier par au moins une cascade.

7. Dispositif de traitement de substrats, en particulier en vue de la fabrication de modules photovoltaïques, de préférence en vue de mettre en oeuvre le procédé selon l'une des revendications précédentes, et présentant :
un module d'enlèvement principal (21) suivi par un module (23) de finition d'enlèvement qui présente des dispositifs de pulvérisation (31a, 31 b, 38a, 38b) ou des dispositifs de mouillage pour pulvériser les substrats ou les mouiller avec une solution de traitement (33) mise en circulation dans un circuit fermé le long d'un parcours de transport qui traverse les modules d'enlèvement,
**caractérisé en ce que**
le module d'enlèvement principal (21) présente un premier récipient (48, 48') et un deuxième récipient (49) de solution de traitement, et après avoir pulvérisé ou mouillé des substrats, la solution de traitement étant amenée dans un deuxième récipient séparé du premier récipient par une paroi (51, 51') rendu perméable aux liquides par des découpes ou similaires réalisées dans une partie située nettement en dessous du niveau de la surface de la solution de traitement qui s'y trouve,
**en ce qu'**il présente des moyens (36) qui prélèvent la solution de traitement dans le premier récipient et la renvoie dans le circuit de pulvérisation ou de mouillage de substrats,
**en ce qu'**une cuve (59) à mousse est disposée à côté du deuxième récipient et
**en ce qu'**il présente des moyens (61a, 61b) situés au-dessus du deuxième récipient pour déplacer la mousse présente à la surface de la solution de traitement présente dans le deuxième récipient jusque dans la cuve à mousse par une paroi latérale (50) du deuxième récipient (49).

8. Dispositif selon la revendication 7, **caractérisé en ce qu'**un dispositif plat de collecte (44) prévu dans le module d'enlèvement principal présente un tube de renvoi (46) qui conduit dans le deuxième récipient.

9. Dispositif selon la revendication 8, **caractérisé en ce que** le tube de renvoi (46) s'étend dans le deuxième récipient (49) en dessous du niveau de la surface de la solution de traitement qui s'y trouve et de préférence dans le tiers inférieur.

10. Dispositif selon les revendications 8 ou 9, **caractérisé en ce que** le tube de renvoi (46) est configuré pour réduire la formation de mousse de la solution de traitement qui le traverse, en particulier par au moins un coude.

11. Dispositif selon l'une des revendications 7 à 10, **caractérisé en ce qu'**un dispositif de pulvérisation (61c) orienté vers l'intérieur de la cuve (59) à mousse est prévu pour rabattre la mousse qui s'y trouve pour la ramener dans la solution de traitement.

12. Dispositif selon l'une des revendications 7 à 11, **caractérisé par** un bain d'immersion (45') qui présente la solution de traitement des substrats dans le module d'enlèvement principal sous la forme d'un dispositif de mouillage, et en particulier aussi dans le module d'enlèvement de finition, un débordement du bain d'immersion dans le deuxième récipient étant de préférence prévu.

13. Dispositif selon la revendication 12, **caractérisé par** des tubes de projection (65a, 65b) disposés au-dessus et en dessous du parcours de traversée des substrats dans le bain d'immersion, pour leur apporter la solution de traitement ou les mouiller par cette dernière de manière contrôlée.

14. Dispositif selon l'une des revendications 7 à 13, **caractérisé par** un conduit en cascade (40) d'un récipient de collecte de solution de traitement du module d'enlèvement de finition jusque dans le deuxième récipient du module d'enlèvement principal.
